# EUROPEAN PATENT APPLICATION

(11) **EP 4 719 005 A2**
(43) Date of publication of application: **01.04.2026**
(21) Application number: 25199945.4
(22) Date of filing: 03.09.2025
(51) Int. Cl.: H10F 71/00, H10F 77/20, H01B 1/00

(54) **PATTERN TRANSFER PRINTING METHODS FOR PRINTING ULTRAFINE LINES**

(30) Priority: 25.09.2024 US 202418895907
(71) Applicant: Wuhan Dr Laser Technology Corp., Ltd., Wuhan 430078 (CN)
(72) Inventor: Cohen, Eyal, 4420801 Keren Avraham 1, Kfar-Saba (IL); Cohen, Natali, 5250178 Hamatmid 40, Ramat Gan (IL); Finarov, Moshe, 7647013 16/7 Einstein Street, Rehovot (IL); Gilon, Hagit, 7634301 Yavne Road 6, Rehovot (IL)
(74) Representative: Pearl Cohen UK

(57) **Abstract**

Pattern transfer printing (PTP) methods are provided, which comprise: (i) handling a tape with multiple pattern transfer sheets having patterns of trenches, to controllably deliver the pattern transfer sheets for paste filling and consecutively for pattern transfer, (ii) mixing, continuously and uniformly, at least two types of conductive printing pastes having different particle sizes and/or at least one type of conductive printing paste with a NIR (near infrared) absorbing dye - to form a uniform paste mixture, (iii) filling the trenches on the delivered pattern transfer sheets with the paste mixture, (iv) controllably delivering wafers for the pattern transfer, and (v) transferring the paste mixture from the pattern transfer sheets onto the delivered wafers, by releasing the paste mixture from the trenches upon illumination by a laser beam. The methods yield highly accurate, ultrafine conductive lines, e.g., for photovoltaic (PV) applications.

## Description

### BACKGROUND OF THE INVENTION

### 1. TECHNICAL FIELD

The present invention relates to the field of pattern transfer printing (PTP), and more particularly, to producing photovoltaic cells.

### 2. DISCUSSION OF RELATED ART

Printing metal features on a receiving substrate is usually carried out by applying high viscosity metal pastes based mainly on metal powders of silver, or copper, gold or other metal powders combined with liquid organic components. Printing conductor (metal) lines (also called fingers) on silicon PV (photovoltaic) cells is a critical manufacturing step that strongly affects the cell efficiency and cost. Recent progress in PV cell design and processing, e.g., PERC (Passivated Emitter and Rear Contact), TOPCon (Tunnel Oxide Passivated Contact) and HJT (Heterojunction with intrinsic thin layer), requires continuous reducing the width of the finger lines down to 10 microns or even less. Such width reduction poses significant challenges in at least two aspects of the PV cells processing: (i) qualitative printing of ultra-fine metal finger lines with the required high aspect ratio, and (ii) low line and contact resistance in spite of very small line cross-section and very small contact area between the printed line and the silicon wafer.

The challenge of the printing technology may be met by replacing the currently used method of screen printing (SP), which is limited for printing ultra-fine lines, by a Pattern Transfer Printing (PTP), which already proved an ability of printing ultra-fine silver lines - see for example Lossen et al. (2015), Pattern Transfer Printing (PTP™) for c-Si solar cell metallization, 5th Workshop on Metallization for Crystalline Silicon Solar Cells, Energy Procedia 67:156-162, which is incorporated herein by reference in its entirety, teaching pattern transfer printing (PTP^{™}) as a non-contact printing technology for advanced front side metallization of c-Si PV solar cells, which is based on laser-induced deposition from a polymer donor substrate comprising a plurality of trenches filled with a metal paste.

Shin et al. 2015 (Bimodally dispersed silver paste for the metallization of a crystalline silicon solar cell using electrohydrodynamic jet printing, Solar Energy Materials & Solar Cells 136: 148-156) and Han et al. 2008 (Preparation of Conductive Silver Paste Using Bimodal Particles, Journal of Nanoscience and Nanotechnology 8: 5576-5580), both incorporated herein by reference in their entirety - teach bimodally dispersed silver pastes for electrohydrodynamic jet printing, and for screen printing, respectively.

### SUMMARY OF THE INVENTION

The following is a simplified summary providing an initial understanding of the invention. The summary does not necessarily identify key elements nor limit the scope of the invention, but merely serves as an introduction to the following description.

One aspect of the present invention provides a pattern transfer printing (PTP) method comprising: handling a tape comprising, as sections thereof, a plurality of pattern transfer sheets having respective patterns of trenches, to controllably deliver the pattern transfer sheets for paste filling and consecutively for pattern transfer, mixing, continuously and uniformly, at least two types of conductive printing pastes having different particle sizes - to form a uniform paste mixture, filling the trenches on the delivered pattern transfer sheets with the paste mixture, controllably delivering a plurality of wafers for the pattern transfer, and transferring the paste mixture from the pattern transfer sheets onto the delivered wafers, by releasing the paste mixture from the trenches upon illumination by a laser beam.

One aspect of the present invention provides a pattern transfer printing (PTP) method comprising: handling a tape comprising, as sections thereof, a plurality of pattern transfer sheets having respective patterns of trenches, to controllably deliver the pattern transfer sheets for paste filling and consecutively for pattern transfer, mixing, continuously and uniformly, at least one type of conductive printing paste with a NIR (near infrared) absorbing dye - to form a uniform paste mixture, filling the trenches on the delivered pattern transfer sheets with the paste mixture, controllably delivering a plurality of wafers for the pattern transfer, and transferring the paste mixture from the pattern transfer sheets onto the delivered wafers, by releasing the paste mixture from the trenches upon illumination by a laser beam, wherein the NIR absorbing dye is configured to absorb at a wavelength of the illumination by the laser beam.

These, additional, and/or other aspects and/or advantages of the present invention are set forth in the detailed description which follows; possibly inferable from the detailed description; and/or learnable by practice of the present invention.

### BRIEF DESCRIPTION OF THE DRAWINGS

For a better understanding of embodiments of the invention and to show how the same may be carried into effect, reference will now be made, purely by way of example, to the accompanying drawings in which like numerals designate corresponding elements or sections throughout.

In the accompanying drawings:
**Figure 1A** is a high-level schematic flowchart illustrating a pattern transfer printing (PTP) method, according to some embodiments of the invention.
**Figure 1B** is a high-level schematic cross section illustration of pattern transfer sheets on a tape, according to some embodiments of the invention.
**Figure 1C** is a high-level schematic cross section illustration of transferring lines of paste mixture, filled into trenches on the pattern transfer sheet, from the pattern transfer sheet to a substrate, according to some embodiments of the invention.
**Figure 2** provides comparative reflectance measurements for disclosed paste compositions according to some embodiments of the invention, with prior art paste.
**Figures 3B-3D** provides comparative images of printed lines of disclosed paste compositions according to some embodiments of the invention, with lines printing with prior art paste **(****Figure 3A****).**
**Figure 4A** provides a cross-sectional image of a printed line of disclosed paste mixture with coarse and fine silver particles according to some embodiments of the invention, compared with **Figure 4B** that provides a cross-sectional image of a printed line of prior art paste, with coarse silver particles only.
**Figure 5** is a high-level schematic side view illustration of units and elements in PTP systems, according to some embodiments of the invention.
**Figures 6A-6C** are high-level schematic illustrations of the filling head, according to some embodiments of the invention.

It will be appreciated that for simplicity and clarity of illustration, elements shown in the figures have not necessarily been drawn to scale. For example, the dimensions of some of the elements may be exaggerated relative to other elements for clarity. Further, where considered appropriate, reference numerals may be repeated among the figures to indicate corresponding or analogous elements.

### DETAILED DESCRIPTION OF THE INVENTION

In the following description, various aspects of the present invention are described. For purposes of explanation, specific configurations and details are set forth in order to provide a thorough understanding of the present invention. However, it will also be apparent to one skilled in the art that the present invention may be practiced without the specific details presented herein. Furthermore, well known features may have been omitted or simplified in order not to obscure the present invention. With specific reference to the drawings, it is stressed that the particulars shown are by way of example and for purposes of illustrative discussion of the present invention only, and are presented in the cause of providing what is believed to be the most useful and readily understood description of the principles and conceptual aspects of the invention. In this regard, no attempt is made to show structural details of the invention in more detail than is necessary for a fundamental understanding of the invention, the description taken with the drawings making apparent to those skilled in the art how the several forms of the invention may be embodied in practice.

Before at least one embodiment of the invention is explained in detail, it is to be understood that the invention is not limited in its application to the details of construction and the arrangement of the components set forth in the following description or illustrated in the drawings. The invention is applicable to other embodiments that may be practiced or carried out in various ways as well as to combinations of the disclosed embodiments. Also, it is to be understood that the phraseology and terminology employed herein are for the purpose of description and should not be regarded as limiting.

Unless specifically stated otherwise, as apparent from the following discussions, it is appreciated that throughout the specification discussions utilizing terms such as "processing", "computing", "calculating", "determining", "enhancing", "deriving" or the like, refer to the action and/or processes of a computer or computing system, or similar electronic computing device, that manipulates and/or transforms data represented as physical, such as electronic, quantities within the computing system's registers and/or memories into other data similarly represented as physical quantities within the computing system's memories, registers or other such information storage, transmission or display devices.

Embodiments of the present invention provide efficient and economical methods and mechanisms for pattern transfer printing and thereby provide improvements to the technological field of producing electrical contacts, and specifically of producing photovoltaic cells.

Pattern transfer printing (PTP) methods are provided, which comprise: (i) handling a tape with multiple pattern transfer sheets having patterns of trenches, to controllably deliver the pattern transfer sheets for paste filling and consecutively for pattern transfer, (ii) mixing, continuously and uniformly, at least two types of conductive printing pastes having different particle sizes and/or at least one type of conductive printing paste with a NIR (near infrared) absorbing dye - to form a uniform paste mixture, (iii) filling the trenches on the delivered pattern transfer sheets with the paste mixture, (iv) controllably delivering wafers for the pattern transfer, and (v) transferring the paste mixture from the pattern transfer sheets onto the delivered wafers, by releasing the paste mixture from the trenches upon illumination by a laser beam. The methods yield highly accurate, ultrafine conductive lines, e.g., for photovoltaic (PV) applications (also termed "fingers").

In the following, a disclosure of the use of two or more types of paste and/or use of an intermixed releasing dye is provided, followed by a general description of PTP systems as more fully provided in U.S. Patent Application No. 18/429,655, and a description of options for intermixed dye in the paste, as more fully provided in U.S. Patent Application No. 17/971,689. Both applications are incorporated herein by reference in their entirety.

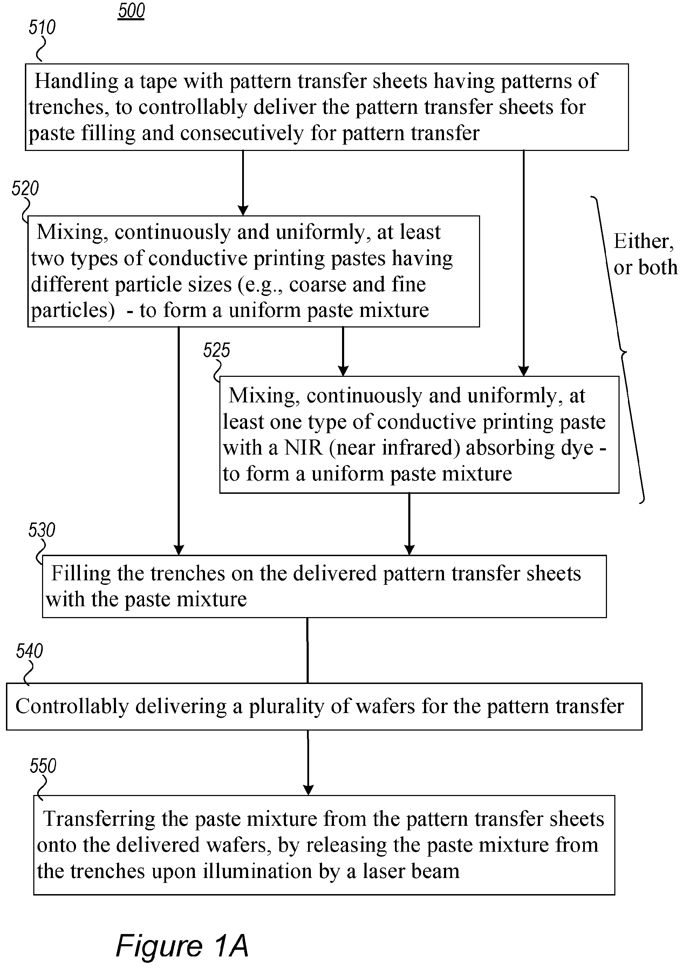

**Figure 1A** is a high-level schematic flowchart illustrating a pattern transfer printing (PTP) method **500,** according to some embodiments of the invention. The method stages may be carried out with respect to any PTP system, e.g., as described herein, which may optionally be configured to implement method **500.** Method **500** may be at least partially implemented by at least one computer processor or by at least one control unit **105** (e.g., one or more personal computers, PCs and/or one or more programmable logic controllers, PLCs) or by their combinations). Certain embodiments comprise computer program products comprising a computer readable storage medium having computer readable program embodied therewith and configured to carry out the relevant stages of PTP method **500.** PTP method **500** may comprise the following stages, irrespective of their order.

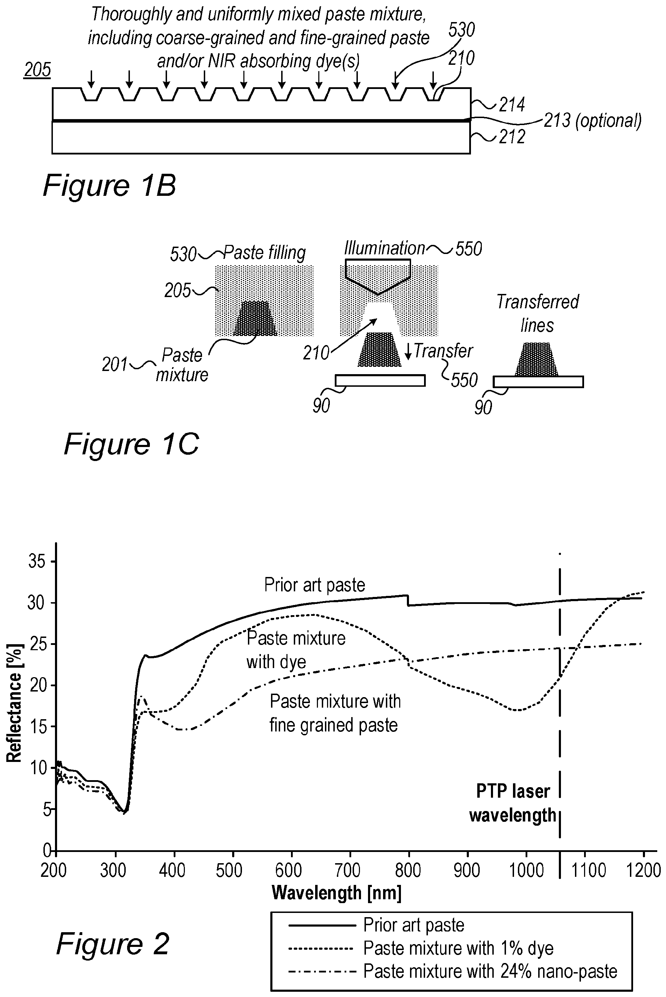

PTP method **500** comprises handling a tape comprising, as sections thereof, a plurality of pattern transfer sheets having respective patterns of trenches, to controllably deliver the pattern transfer sheets for paste filling and consecutively for pattern transfer (stage **510);** mixing, continuously and uniformly, at least two types of conductive printing pastes having different particle sizes - to form a uniform paste mixture (stage **520)** and/or mixing, continuously and uniformly, at least one type of conductive printing paste with a NIR (near infrared) absorbing dye - to form a uniform paste mixture (stage **525);** filling the trenches on the delivered pattern transfer sheets with the paste mixture (stage **530);** controllably delivering a plurality of wafers for the pattern transfer (stage **540);** and transferring the paste mixture from the pattern transfer sheets onto the delivered wafers, by releasing the paste mixture from the trenches upon illumination by a laser beam onto a receiving substrate (e.g., silicon wafers) (stage **550).** See also **Figure 1C** for a highly schematic illustration.

The arrows in **Figure 1A** indicate schematically three different types of embodiments disclosed herein: (i) mixing, continuously and uniformly, at least two types of conductive printing pastes having different particle sizes (stage **520),** (ii) mixing, continuously and uniformly, at least one type of conductive printing paste with a NIR absorbing dye (stage **525),** or (iii) mixing, continuously and uniformly, both at least two types of conductive printing pastes having different particle sizes and at least one type of conductive printing paste with a NIR absorbing dye (stages **520** and **525)** - to form the uniform paste mixture.

In some embodiments, the at least two types of conductive printing pastes may comprise at least a first, coarse-grained type having a median particle size (e.g., diameter) between 0.5-5 µm and a second, fine-grained type having a median particle size (e.g., diameter) between 50-200nm (termed nano-particles). In non-limiting examples, the median particle size of the first, coarse-grained type may be 2µm±1µm and the median particle size of the second, fine-grained type may be 80nm±50nm (e.g., 70-80nm, 80-100nm, 50-80nm or any other intermediate value or subrange).

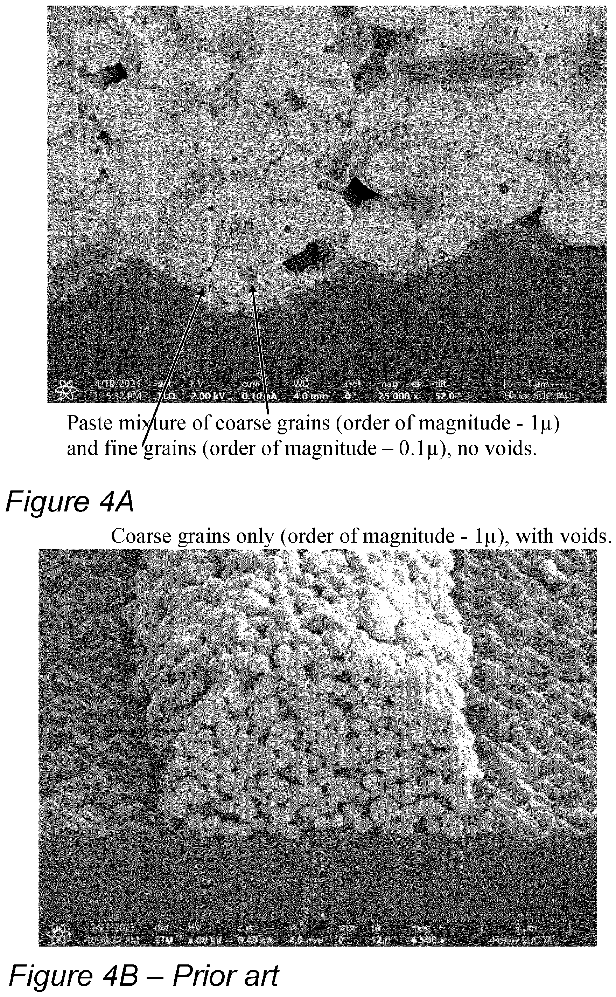

In various embodiments, fine-grained paste(s) may form, e.g., 5-25wt% of the paste mixture. The coarse grains and the fine grains may be made of the same conductive material, e.g., silver. The fine grains may enhance and improve the interface of the paste mixture to the substrate (e.g., silicon) and potentially may improve the electrical conductivity between the substrate and the lines, as well as within the lines by filling in the voids (compare, e.g., **Figure 4A** with **Figure 4B****).**

In some embodiments, the mixing of the at least two types of conductive printing pastes (stage **520)** may further comprise mixing a NIR (near infrared) absorbing dye configured to absorb at a wavelength of the illumination by the laser beam - to form the uniform paste mixture (stage **525).** The NIR absorbing dye may be configured to absorb at a wavelength of the illumination by the laser beam.

In some embodiments, the mixing of the at least one type of conductive printing paste with the NIR absorbing dye (stage **525)** may further comprise mixing at least two types of conductive printing pastes having different particle sizes - to form a uniform paste mixture (stage **520).**

In various embodiments, NIR absorbing dye(s) may comprise any of the dyes disclosed herein, e.g., forming 0.5-5wt% of the paste mixture. It is noted that NIR laser illumination is used as the silicon is practically transparent at this spectral range, so that the laser illumination used to transfer the paste lines does not damage the silicon wafer.

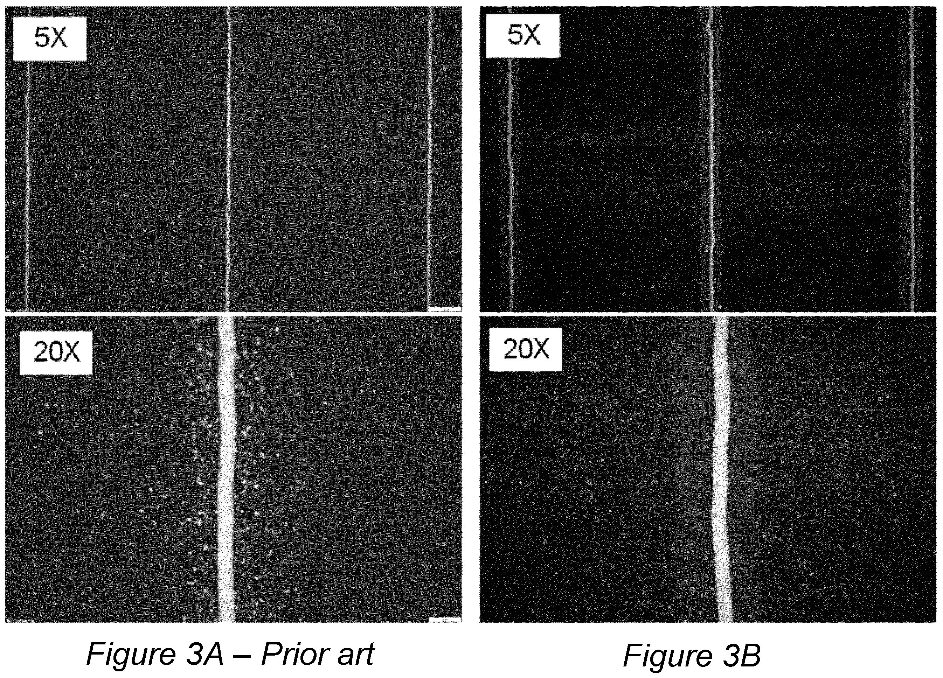

The laser source may comprise a pulsed laser and/or a continuous wave (CW) laser or Quasi-CW laser, e.g. YLM-150/1500-QCW-AC-Y11^{™} of IPG Photonics^{™} Corp. Use of the paste mixtures, either with two or more particles sizes and/or with intermixed NIR absorbing dye(s), may enable reducing the required power of the laser source, e.g., to be about half of the laser power required for prior art printing paste (see, e.g., in the **Table** below concerning **Figures 3A-3D** - an achieved power reduction from 600W to 300W or even 200W), as the reduced reflection reduces the power requirements for releasing the paste lines from the trenches. The inventors note that decreasing the power of the laser source needed for the paste release is unexpected in view of the prior art, which generally teaches increasing the used power to enable releasing narrow finger lines (e.g., around 10µm) at high quality from the correspondingly narrow trenches on the pattern transfer sheet. The inventors note that disclosed PTP methods **500** reduce light reflectance (and accordingly increase illumination absorption by the paste, see, e.g., **Figure 2** for the used NIR wavelength - and therefore allow reducing laser power. In addition, disclosed PTP methods **500** reduce the resulting debris of paste particles near the printed lines - by any of - intermixing the fine-grained paste with the coarse-grained paste or including the NIR-absorbing dye(s). Disclosed PTP methods **500** enable releasing the paste line without use of a dedicated release layer - simplifying the preparation process of the pattern transfer sheets on the tape and reducing the cost of manufacturing.

In various embodiments, PTP method **500** may be configured to form transferred paste lines (fingers) that are at most 10µm wide and have an aspect ratio of at least 0.8.

In various embodiments, PTP method **500** may be configured to form transferred paste lines (fingers) that are uniform and have a low waviness, with minimal debris (see, e.g., **Figures 3B-3D****).**

The inventors experimentally realized that the quality of printed ultrafine lines strongly depends on the quality of mixing the paste mixtures. The best conditions for mixing the paste may be achieved using filling unit **122** of the printing system just before filling the trenches in the pattern transfer sheet **530.** The continuous mixing of the paste during operation of filling unit **122** ensures that the paste does not separate or dry between the initial mixing and the application of the paste.

Disclosed PTP method **500** yield highly accurate, ultrafine conductive lines, e.g., for photovoltaic (PV) applications. The transferred lines are uniform, are characterized by a high aspect ratio, low waviness, and the disclosed PTP methods result in minimal debris, while reducing the required power output of the laser source - as less radiation is reflected from the paste mixture after adding either the fine grain paste or the NIR absorbing dye to the coarse grain paste - see, e.g., **Figure 2****).**

**Figure 1B** is a high-level schematic cross section illustration of tape (pattern transfer sheet) **205,** according to some embodiments of the invention. **Figure 1C** is a high-level schematic cross section illustration of transferring lines of paste mixture **201,** filled into trenches **210** on pattern transfer sheet **205** (in paste filling stage **530),** from pattern transfer sheet **205** to a substrate **90** (e.g., a silicon wafer, in paste transfer stage **550),** according to some embodiments of the invention. In certain embodiments, tape **205** may be transparent to laser illumination and comprise at least a top polymer layer **214** comprising trenches **210** formed by press molding, pneumatic molding or laser molding thereon. In the illustrated non-limiting example, trenches **210** are illustrated in a non-limiting manner as being trapezoid in cross section. Thoroughly and uniformly mixed paste mixture, including coarse-grained and fine-grained paste and/or NIR absorbing dye(s) is filled into the trenches by a paste filling unit **120** with a filling head **122** and later released from the trenches by the laser illumination onto the wafers to form conductive lines (fingers) **(****Figure 1C**), as further described below. Further details are disclosed below, and in U.S. Application No. 17/971,689, which is incorporated herein by reference in its entirety.

**Figure 2** provides comparative reflectance measurements for disclosed paste compositions according to some embodiments of the invention, with prior art paste. **Figure 2** provides a comparison of the reflectance as a function of the illumination wavelength - of a prior art silver paste (SOL9681^{™} paste manufactured by Heraeus^{™}), and of two disclosed paste mixtures: one with fine-grained paste (SOL9681^{™} paste mixed with 24wt% Metalon HPS-U11^{™} paste manufactured by Novacentrix^{™} - the former having in average 2µm silver particles and the latter having in average 80nm silver nano-particles) and another with NIR absorbing dye (SOL9681^{™} paste mixed with 1wt% LUNIR5 dye powder manufactured by Luminochem company ). The reflectance measurements are made on a Cary 4000^{™} spectrophotometer equipped with an integrated sphere and calibrated with a Spectralon^{™} Diffuse Reflective material. As the results show, both mixing the fine-grained paste and mixing the NIR absorbing dye into the prior art paste reduced the reflectivity of the paste mixture compared to the prior art paste over most of the measured range - in the visible and infrared ranges between 400-1100nm and beyond. Specifically, at the NIR laser wavelength of 1060-1070nm both mixtures reduced reflectivity from 30% to between 20-25% - resulting in significant reductions in the required laser power to achieve the same paste release forces. It is noted that due to the broad wavelength range in which reflectance is reduced, disclosed paste mixtures have similar benefits when using other types of lasers, at other wavelengths within the range 400-1100nm. It is also noted that the paste mixture of coarse and fine grained pastes yields a larger reduction in reflectance than NIR absorbing dyes in the visible range (400-800nm) as well as in NIR beyond 1100nm.

In non-limiting examples, paste mixtures may include between 0.5-5wt% of NIR absorbing dye (e.g., between 0.5-1wt%, 1-2wt%, 2-3wt%, 3-5wt% or any intermediate value) and/or between 10-50wt% of fine-grained particles (nanoparticles) (e.g., between 10-20wt%, 20-30wt%, 30-50wt% or any intermediate value) - either or both intermixed with coarse-grained particles.

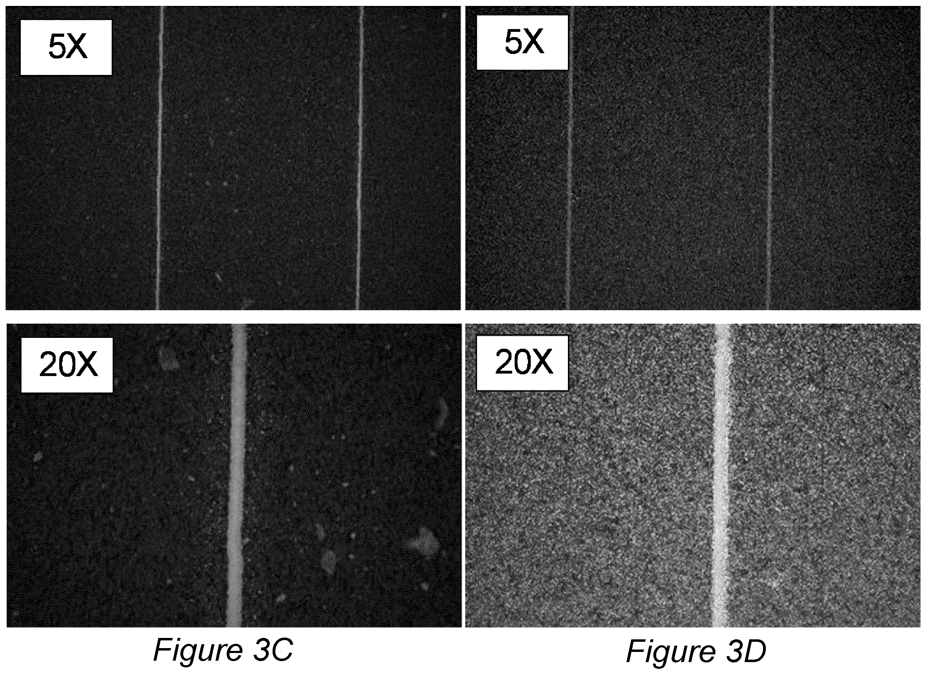

**Figures 3B-3D** provides comparative images of printed lines of disclosed paste compositions according to some embodiments of the invention, with lines printing with prior art paste **(****Figure 3A****).** Each line is shown in 5x and 20x optical magnification, and the required power, line dimension (width and aspect ratio - width divided by height) and degrees of debris and waviness of the lines are indicated in the **Table** below. Disclosed PTP methods **500** were thus shown to improve PTP performance, yielding cleaner, thinner and straighter deposited lines and using less illumination power. The coarse and fine particles mixtures in both **Figure 3B** and **3D** included SOL9681^{™} coarse-grained paste mixed with 24wt% Metalon HPS-U11^{™} fine-grained paste, and the NIR absorbing dye in **Figure 3C** and **3D** included 1wt% LUNIR5 dye - compared with prior art SOL9681^{™} paste **(****Figure 3A****).**

**Table: Comparison of performance by disclsoed methods, compared to the prior art.**

| | Required laser power | Achieved line width | Achieved aspect ratio | Level of line waviness | Level of debris |
|---|---|---|---|---|---|
| Prior art paste, **Figure 3A** | 600W | 24-27µm | 0.4-0.46 | High | High |
| Disclosed paste mixture - coarse and fine grains, **Figure 3B** | 300W | 22µm | 0.55 | Medium | Low |
| Disclosed paste mixture - with NIR absorbing dye, **Figure 3C** | 300W | 21µm | 0.59 | Low | Low |
| Disclosed paste mixture - coarse and fine grains, and with NIR absorbing dye, **Figure 3D** | 200W | 21µm | 0.62 | Low | No debris |

Disclosed PTP methods **500** reduce the power level of the laser source that was required to transfer the lines from the trenches on the pattern transfer sheet to the wafer. While transferring prior art paste required 600W of laser power, disclosed paste mixtures required merely half the power - 300W, or even a third of the power - 200W, for the transferring, mainly due to the reduced reflectance of the paste mixtures (see, e.g., **Figure 2****).**

Disclosed PTP methods **500** enable printing thinner lines (21-22µm compared with prior art 24-27µm, ca. 20% thinner) with higher aspect ratios (0.62 compared with prior art 0.4-0.46, ca. 50% higher aspect ratios) than prior art methods.

Printing lines using disclosed PTP methods **500** results in cleaner lines (less or no printing paste debris on the substrate) and lower waviness (more uniformly straight lines).

Initial results further indicate that disclosed PTP methods **500** also resulted in improved physical contact among the silver particles and between the silver particles and the substrate (which may also contribute to reduce the line resistance and/or reduce the contact resistance between the lines and the silicon substrate).

**Figure 4A** provides a cross-sectional image of a printed line of disclosed paste mixture with coarse and fine silver particles according to some embodiments of the invention, compared with **Figure 4B** that provides a cross-sectional image of a printed line of prior art paste, with coarse silver particles only. As evidenced in **Figure 4A****,** fine-grained particles fill-in the voids between coarse-grained metal grains and the wafer silicon texture - and potentially (i) reduce the finger line resistance, as well as (ii) enable better interface between the printed lines and the textured silicon substrate - potentially increasing the efficiency of the PV cells. The inventors point out that thorough continuous mixing of the paste to yield the uniform paste mixture yields the even distribution of nano-particles (fine-grained particles) among the micro-particles (coarse-grained particles) - which potentially may improve the electrical conductivity within the lines and between the lines and the substrate **(****Figure 4A****)** compared with prior art coarse-grain lines **(****Figure 4B****).** Moreover, incorporation of the nano-particles of the same material (e.g., silver) into the finger lines does not require any additional processes (like cleaning the dye particles from the silicon surface in case of using a dedicated release layer).

Advantageously, compared to prior art pre-mixed pastes, disclosed PTP methods **500** (i) do not require any premixing, which may deteriorate in uniformity with time and upon use (smaller and larger particles may separate within the paste during storage, transportation or application), (ii) enable adjustment of the exact paste composition for each prepared batch, (iii) control the degree of illumination absorption by the paste mixture (which too may deteriorate over time for premixed pastes) and (iv) ensure continuous and uniform mixing of the paste throughout the printing process - enabling consistent high-quality printing. For example, disclosed PTP methods **500** provide advantages over using prior art bimodally dispersed metal pastes, as the fine-grained particles are significantly smaller than available in such pastes (e.g., due to processing and storage limitations, the smaller grains in commercial bimodally dispersed metal pastes are typically between 100-300 nm, rather than disclosed 70-80nm, which make a large difference in the functionality of the paste - filling voids, improving conductivity, etc.). Moreover, disclosed paste mixtures are configured to be transferred by disclosed PTP methods **500,** in contrast to prior art bimodal paste mixtures which are configured to be applied by ink jet printing or screen printing, and hence have completely different characteristics adjusted to these application methods.

Advantageously, with respect to the increasingly high line aspect ratios required, which lead to the contact width of the line to the silicon substrate being reduced to relatively few coarse-grain particles (2µm grain size compared to 10µm line width, and also see, e.g., **Figure 4B****)** - disclosed PTP methods **500** increase and improve the contact area between the lines and the substrate - providing more surface area of the conductive particles and improving the compliance of the transferred line to the roughness of the silicon substrate - through the intermixing the fine-grained particles (see, e.g., **Figure 4A****).**

In some embodiments, using paste mixtures including both coarse-grained and fine-grained particles as well as NIR-absorbing dye(s) may further enhance PTP performance and the quality of the printed lines.

In certain embodiments, disclosed PTP methods **500** may also enable printing lines with high aspect ratios (narrower and higher lines, with larger height to width ratios), due to the better conductivity, the lower degree of waviness (straighter lines) and reduced debris. Advantageously, disclosed PTP methods **500** may not require post-treatment of the transferred lines (e.g., by heat), e.g., to remove paste debris or other residues and/or to increase their conductivity.

The high degree of uniformity of the paste mixtures is achieved by disclosed PTP methods **500** by continuous movement of the paste mixture through a paste filling head **122** described below.

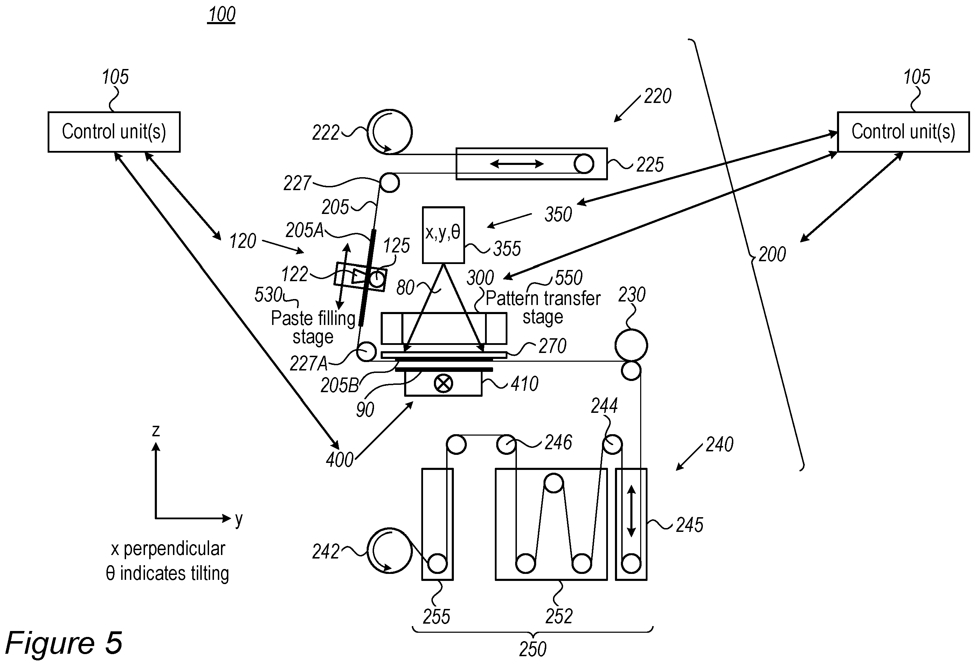

**Figure 5** is a high-level schematic side view illustration of units and elements in PTP systems **100,** according to some embodiments of the invention. The highly schematic side view illustration of **Figure 5** provides a non-limiting example for the arrangement of elements in tape handling unit **200** with respect to paste filling unit **120** (e.g., carrying out paste filling stage **530)** and paste transfer unit **350** (e.g., carrying out pattern transfer stage **550).** Units and elements illustrated in **Figure 5** are described briefly below, with more details of non-limiting embodiments providing in the consecutive figures. One or more control units **105,** may be configured to monitor and/or control the units of PTP system **100,** possibly via various processors, and coordinate the operation of PTP system **100.** It is noted that corresponding PTP methods are described in more details in U.S. Application No. 18/429,655, which is incorporated herein by reference in their entirety.

PTP system **100** is configured to apply patterns of conductive material onto wafers by non-contact printing. PTP system **100** comprises a tape handling unit **200** configured to handle a tape **205** comprising, as sections thereof, a plurality of pattern transfer sheets **205A, 205B** having respective patterns of trenches, and to controllably deliver pattern transfer sheets for paste filling **205A** and consecutively for pattern transfer **205B,** respectively. Tape handling unit **200** is configured to move tape **205** in a step-and-repeat manner (sheet by sheet) from an unwinder roll **222** to a re-winding roll **242.** PTP system **100** further comprises a paste filling unit **120** configured to fill the trenches on delivered pattern transfer sheets **205A** with conductive printing paste. Tape handling unit **200** may be further configured to deliver the pattern transfer sheets one-by-one for the paste filling (denoted sheets **205A)** and/or for the pattern transfer (denoted sheets **205B)** with continuous monitoring of the tension and the Machine Direction (MD, along the tape movement) and Cross Machine Direction (CMD, perpendicularly to MD) positions of tape **205.** PTP system **100** further comprises a wafer handling and positioning unit **400** configured to controllably deliver a plurality of wafers **90** for the pattern transfer, at a close proximity (e.g., in a range of between 0.1mm and 0.5mm) to the pattern transfer sheet. The PTP system **100** further comprises a paste transfer unit **350** configured to transfer the conductive printing paste from respective pattern transfer sheet **205B** onto respective delivered wafer **90B,** by releasing the printing paste from the trenches upon illumination by a laser beam **80.**

The units of PTP system **100** are mounted on a rigid frame in a compact manner, to minimize the system's footprint. As a general design feature, tape handling is carried out along a vertical direction (denoted "z") and along one horizontal direction (denoted "y", termed machine direction, MD), while wafer handling is carried out along a perpendicular direction thereto, e.g., in another horizontal direction (denoted "x", termed cross machine direction, CMD).

Tape handling unit **200** may be configured to deliver pattern transfer sheets one-by-one for the paste filling (e.g., pattern transfer sheet **205A)** - at paste filling process stage **530,** by help of a moving paste filling head **122** - and/or for the pattern transfer (e.g., pattern transfer sheet **205B)** - in a paste pattern transfer unit carrying out paste transfer process stage **550,** by help of a movable scanner **355** (e.g., moveable along the x and y axes and optionally tiltable at an angle θ, or possibly an optical head that scans along the y axis, is moveable along the x axis and optionally tiltable at an angle θ. For example, paste filling unit **120** and pattern transfer sheet **205B** plane may be set at an angle deviating 0-30° from the vertical x-z plane.

In embodiments, one or more top dancer **225** and bottom dancer **245** may be configured to buffer the step-and-repeat movement of tape **205** from unwinder roll **222** and to re-winding roll **242,** respectively, as pattern transfer sheet **205A** is being filled with paste and/or as paste from pattern transfer sheet **205B** is being transferred, so as to ensure that these are carried out with the respective pattern transfer sheet in static positions. Top dancer(s) **225** and/or bottom dancer(s) **245** may be configured to maintain the tension in tape **205** moving through at least a part of PTP system **100.**

It is noted that in PTP system **100,** paste filling unit **120** is positioned almost vertically (along the z axis) to ensure a short travelling distance of pattern transfer sheet **205A** from paste filling to pattern transfer sheet **205B** at paste transfer unit **350** thus enabling to minimize changes of the filled paste condition (e.g., due to drying before printing) . For example, the near-vertical position may be configured to enable a smaller movement distance for the pattern transfer sheets from state **205A** to state **205B,** and thereby optionally to locate the laser scanner just behind the vertical filling unit, closer to roll **227A** positioned between **205A** and **205B,** illustrated schematically in **Figure 5****.** The near-vertical position of paste filling unit **120** is advantageous with respect to prior art horizontal position of paste filling units, as it reduces the distance between the paste filling position **(205A)** and the paste transfer position **(205B)** of the pattern transfer sheet **205.**

A front side of PTP system **100** may be configured to have unwinder roll **222** and re-winding roll **242** easily accessible for replacement and maintenance requirements, as well as have paste filling unit **120** easily accessible for paste filling and maintenance requirements - from same front side **102.**

PTP system **100** may optionally comprise a tape re-use unit **250** configured to clean pattern transfer sheets after the pattern transfer to provide reusable pattern transfer sheets. For example, tape re-use unit **250** may comprise a tape cleaning unit **252** in which tape **205** may be cleaned mechanically, e.g., using scraper(s), ultrasound, and/or other means, and/or chemically using cleaning solutions; and a tape drying unit **255,** with idle rolls **244, 246** positioned as needed to maintain safe tape movements. Tape **205** may be moved by one or more tape drive motor(s) **230** (illustrated schematically), and further supported by one or more rolls **227** along the way of tape **205** through PTP system **100.**

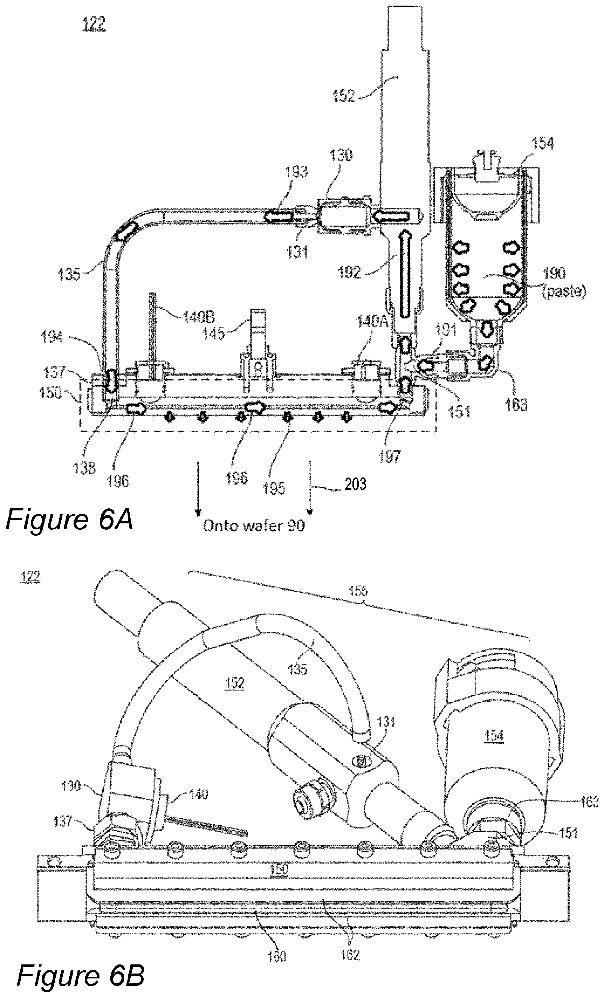

Paste filling unit **120** may comprise moveable paste filling head **122** and a countering moveable roll **125** configured to support a back side of pattern transfer sheet **205A** during the paste filling. A non-limiting example for paste filling unit **120** is illustrated with more details in **Figures 6A-6C****.**

In certain embodiments, wafer handling and positioning unit **400** may comprise at least one stage **410** enabling movement in x and z axes (termed in the following - the x,z-stage), with each stage **410** comprising at least one holder, and with each holder supporting wafer **90** and enabling wafer movement in y and θ axes (θ axis relates to rotation of a wafer with respect to the x-y plane). In certain embodiments, two x,z-stages **410** of wafer handling and positioning unit **400** may be configured to operate in parallel with respect to each other. Each stage **410** may comprise two holders for holding wafers **90,** each holder ensuring wafer movement in y, θ - axis thus enabling faster wafer handling and continuous wafers movement during pattern transfer. Multiple cameras imaging incoming wafers enable more accurate wafer alignment within the printing system thus more accurate alignment of printed conductive lines onto wafer pattern.

Paste transfer unit **350** (e.g., a laser scanner, e.g., a pulsed laser or a continuous wave - CW laser) may comprise a laser scanner (scanning head) **355** (e.g., movable along CMD, e.g., by a linear stage, a ball-screw stage, etc.) configured to control the illumination of pattern transfer sheets **205B** by the laser beam for depositing the paste from the patterned trenches of pattern transfer sheets **205B.**

PTP system **100** may further comprise a print quality control unit(s) (not shown) configured to control a print quality of the pattern transfer, in particular to detect tiny defects such as openings or gaps within the printed fingers or other defects in the pattern that was transferred onto the wafer. For example, print quality control unit(s) may be based on imaging cameras, which transfer the acquired images of inspected wafers to processor(s) for image processing.

Tape handling unit **200** may be configured to move tape **205,** while delivering pattern transfer sheets **205A** one-by-one for the paste filling (at paste filling unit **120)** and/or for the pattern transfer (at pattern transfer unit **350)** by continuously controlling the tape tensions and accurate position of the sheets in both MD and CMD coordinates.

The CMD positions of unwinder roll **222** and re-winding roll **242** may be continuously controlled and if needed corrected by help of one or more control unit(s) **105,** e.g., by controlling driving motor(s) thereof. Top dancer(s) **225** and bottom dancer(s) **245** may be configured to support fast stepwise movements of pattern transfer sheets **205A, 205B** (as segments of tape **205)** to their respective positions for paste filling and pattern transfer. Idle rolls **227** (only some of which indicated) may be configured to direct tape movement through tape handling unit **200.**

Tape handling unit **200** may be configured to enable fast and accurate provision and changing of the tape segments (pattern transfer sheets) used to print the wafers. Tape handling unit **200** may be further configured to have a compact design with a minimal footprint, and be set within a stable and rigid frame or chassis for supporting its operation and also for enabling easy maintenance. Tape re-use unit **250** may be set within the frame and in the path of tape **205** and enable reusing tape **205** - making the overall process more efficient and economical.

Disclosed PTP methods **500,** PTP systems **100** and tape **205** may be used to print ultrafine lines of metallic paste mixture(s) to produce electronic circuits, e.g., creating conductive lines or pads or other features on laminates for PCBs or other printed electronic boards, or on silicon wafers, e.g., for photovoltaic (PV) cells. Other applications may comprise creating conductive features in the manufacturing processes of mobile phones antennas, decorative and functional automotive glasses, semiconductor integrated circuits (IC), semiconductor IC packaging connections, printed circuit boards (PCB), PCB components assembly, optical biological, chemical and environment sensors and detectors, radio frequency identification (RFID) antennas, organic light-emitting diode (OLED) displays (passive or active matrix), OLED illuminations sheets, printed batteries and other applications. For example, in non-limiting solar applications, the metallic paste may comprise metal powder(s), optional glass frits and modifier(s), volatile solvent(s) and non-volatile polymer(s) and/or or resin(s). A non-limiting example for the paste includes SOL9651B^{™} from Heraeus^{™}.

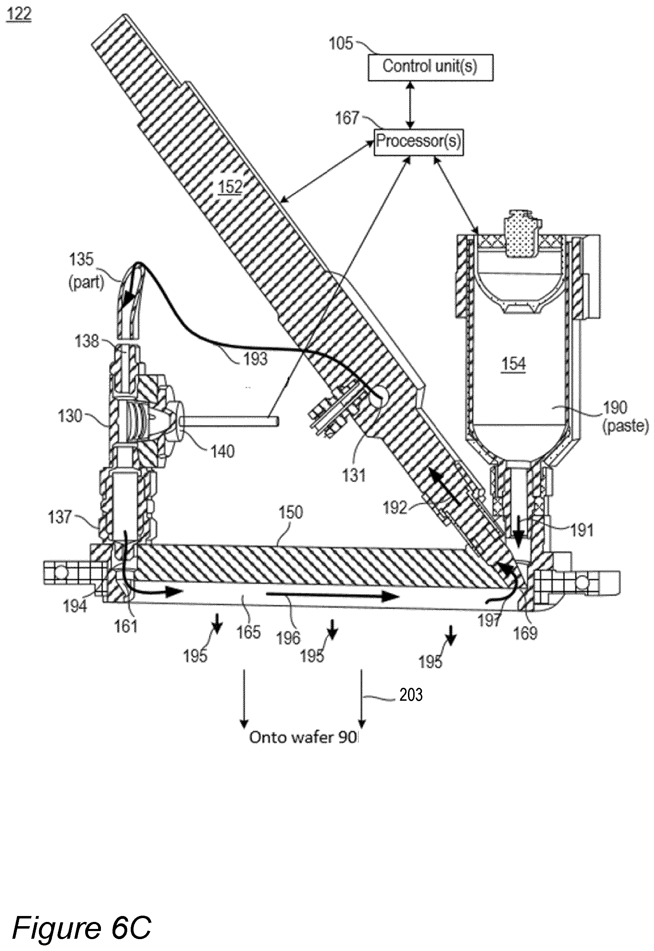

**Figures 6A-6C** are high-level schematic illustrations of filling head **122,** according to some embodiments of the invention. **Figures 6A** and **6C** provide schematic side views in cross section and **Figure 6B** provides a perspective view from below filling head **122.**

Paste filling unit **120** may comprise a frame on which paste filling head **122** and a bottom roll (not shown) are mounted, and with respect to which they are moved simultaneously. Movements of the paste filling head assembly may be controlled by one or more control unit(s) **105** e.g., via controlling a respective flexible rack (not shown) attached to paste filling head **122,** drive motors (not shown) and/or gantry motion system (not shown). The bottom roll may be configured to counter paste filling head **122** and support pattern transfer sheet **205A** of tape **205** during the filling of pattern transfer sheet **205A** with the paste, by paste filling head **122.** The bottom roll may be configured to roll during operation, possibly controllably (see additional details in U.S. Application No. 18/429,655, incorporated herein by reference in its entirety).

Paste filling unit **120** may be configured to enable fast, uniform and accurate filling of the high viscosity paste into the trenches having a high aspect ratio, as described herein concerning PTP methods **500.** Paste filling unit **120** may be further configured to clean the surface of tape **205** after filling, e.g., disclosed in WIPO Publication No. 2015128857, which is incorporated herein by reference in its entirety.

As illustrated schematically in **Figures 6A-6C****,** filling head 122 of paste filling unit **120** may comprise at least two feeding openings **161, 169,** an internal cavity **165** and at least one dispensing opening **160** that are in fluid communication (see, e.g., **Figures 6B** and **6C****)** and a pressurized paste supply unit **155** configured to circulate paste **190** through printing head **150.** The pressure in the pressurized paste supply unit may be adjusted to maintain continuous circulation of the paste mixture through feeding openings **161, 169** and internal cavity **165** and to control dispensing of the paste mixture through dispensing opening(s) **160.** For example, pressurized paste supply unit **155** may comprise a pressurized paste reservoir **154** and a paste pump **152** in fluid communication with internal cavity **165** of printing head **150,** which are configurated to circulate the paste mixture therethrough, as well as to continuously and uniformly mix the paste mixture. In non-limiting examples, paste pump **152** may comprise rotating pressure-tight displacement systems with self-sealing, rotor/stator designs for dispensing precise volumes such as eco-PEN450^{™} from Dymax^{™}.

In various embodiments, paste filling unit **120** comprises at least one pressure sensor **140** configured to measure the pressure of the circulating paste, e.g., pressure sensor **140** illustrated schematically in **Figures 6A-6C** and associated with a paste mixer **130** or pressure sensors **140A, 140B** illustrated schematically in **Figure 6A****,** at either ends of printing head **150,** as non-limiting examples. Alternatively or complementarily, pressure measurement may be implemented within elements of pressurized paste supply unit **155,** such as paste pump **152** and/or paste reservoir **154.** Paste filling unit **120** may further comprise at least one processor **167** and/or controller (shown schematically in **Figure 6C****),** in communication with control unit(s) **105** and configured to adjust the pressure in pressurized paste supply unit **155** (or its components) with respect to the measured pressure of the circulating paste mixture. Paste filling unit **120** may further comprise one or more paste mixer(s) **130** configured to mix the circulating paste mixture. For example, paste mixer(s) **130** may be a static mixer, mixing the paste by utilizing its pressurization. In non-limiting examples, paste mixer(s) **130** may comprise plastic disposable static mixers such as GXF-10-2-ME^{™} from Stamixco^{™} made of large diameter plastic housing that includes multiple mixing elements.

Pressurized paste supply unit **155** may be further configured to introduce the paste mixture into internal cavity **165** via at least one entry opening **161** of the at least two feeding openings and to receive the circulated paste mixture via at least one exit opening **169** of the feeding openings in printing head body **150.** Typically, entry opening(s) **161** and exit opening(s) **169** are at the top of printing head body **150,** opposite to dispensing opening(s) **160** which faces the pattern transfer sheet with trenches which are to be filled by the uniform paste mixture. Alternatively or complementarily, entry opening(s) **161** and/or exit opening(s) **169** may be positioned on sides and/or extension(s) of printing head **150.**

Pressurized paste supply unit **155** may comprise pressure-controlled paste reservoir **154,** paste pump **152** and mixer **130** that are in fluid communication. Pressure-controlled paste reservoir **154** may be configured to deliver paste mixture to paste pump **152,** which may be configured to deliver the paste mixture through mixer **130** to entry opening(s) **161.** Pressurized paste supply unit **155** may be further configured to mix the paste mixture from exit opening(s) **169** with the paste mixture delivered from pressure-controlled paste reservoir **154** to paste pump **152.** For example, as illustrated schematically in **Figures 6A** and **6C****,** paste **190** in paste reservoir **154** may be delivered **(191)** to paste pump **152,** mixing

**(192)** with paste mixture **197** exiting from exit opening(s) **169** of printing head **122,** to be pumped by paste pump **152** into mixer **130.** Paste mixture **193** from mixer **130** may be delivered **(194)** to entry opening(s) **161** of printing head body **150,** wherein paste mixture **196** moves along internal cavity **165** and some paste **195** may be dispensed through dispensing opening(s) **160** to form patterns on the transfer sheet **205** such as lines to be then printed (after the tape movement, from transfer sheet **205)** on the receiving substrate such as wafer **90.** For example, the printed lines (fingers) may comprise silver lines of about 20µm width on silicon wafers for PV cells (see, for non-limiting examples, Lossen et al. 2015), or narrower ultrafine lines having a width around 10µm, 15µm, intermediate values or smaller values. Remaining paste mixture **197** is then mixed with paste mixture **191** from paste reservoir **154** (e.g., delivered through nozzle **163** at junction **151)** to compensate for the dispensed amount, and the paste is circulated through paste filling unit **120** to maintain its mechanical characteristics and support continued mixing of the paste to maintain its uniform composition. In certain embodiments, paste filling unit **120** may be further configured to modify paste composition, e.g., by adding additives such as solvents to keep the paste mixture homogenized, possibly in relation to the monitored pressures throughout paste filling unit **120.** For example, additives such as solvents may be added to the paste entering mixer **130** if needed. While the mixtures of coarse and fine grained pastes or coarse grain paste with NIR absorbing dyes may be initially loaded into paste reservoir **154,** the design of printing head **122** enables proper mixing - thoroughly and uniformly - in mixer **130** and throughout the circulation of the paste mixture through paste filling unit head **122.** The high degree of uniformity of the paste mixtures is achieved by disclosed PTP methods **500** by continuous movement of the paste mixture through paste filling unit head **122.** For example, the paste mixture may be mixed dynamically by paste mixer **130** in paste filling unit **120,** during the paste filling process. Dynamic mixing by paste mixer **130** and within internal cavity **165** of filling unit head **122** as part of the filling process may advantageously enable the best mixing quality and paste uniformity, which is not achievable by using premixed paste without the disclosed continuous and uniform mixing.

In various embodiments, printing head **150,** internal cavity **165** and dispensing slit as opening **160** limited by slit edges **162** (e.g., metallic slit lips) may be elongated (see, e.g., **Figure 6B****)** and configured with respect to paste mixture properties (e.g., viscosity values), specified throughput and specified features (e.g., length, width and optionally cross section) of the lines or other elements that are to be dispensed by printing head **122.** In certain embodiments, dispensing opening **160** may comprise one or more slits, one or more opening, a plurality of linearly-arranged openings, e.g., one or more lines of circular or elliptical openings, and so forth.

In various embodiments, paste material may comprise conductive silver based metallic paste, and may typically be of high viscosity (e.g., in the range of several tens to several hundreds of Pa·s). For example, in non-limiting solar applications, the metallic paste may comprise metal powder(s), optional glass frits and modifier(s), volatile solvent(s) and non-volatile polymer(s) and/or or resin(s). A non-limiting example for the paste includes a mixture of coarse-grained paste (e.g., SOL9651B^{™} from Heraeus^{™}), a fine-grained paste (e.g., Metalon HPS-U11^{™} from Novacentrix^{™}), and/or optionally with a NIR absorbing dye (e.g., LUNIR5 dye powder from Luminochem company).

Paste filling unit **120** may comprise one or more pressure sensor (s) **140, 140A, 140B** configured to measure the pressure of the circulating paste at one or more respective locations along the paste circulation path. For example, pressure sensor(s) **140, 140A, 140B** may be set adjacent to entry opening(s) **161,** exit opening(s) **169,** in fluid communication with internal cavity **165** of printing head body **150** and/or in association with any of mixer **130,** paste reservoir **154** and/or paste pump **152.** Pressure-related indications from pressurized paste reservoir **154** and/or paste pump **152** may also be used to monitor paste circulation through Paste filling head **122** and/or to monitor and possibly modify the paste properties such as its viscosity, e.g., by adding solvent. Paste filling unit **120** may further comprise at least one controller (e.g., as part of or in communication with control unit **105** and/or as at least one computer processor **167** as illustrated in **Figure 6C****),** in communication with any of the components of paste filling unit **120,** e.g., via communication link(s)) configured to adjust the pressure in pressure-controlled paste reservoir **154** and/or paste pump **152** with respect to the measured pressure of the circulating paste, e.g., as received from one or more pressure sensor (s) **140, 140A, 140B.** In non-limiting examples, any of pressure sensor(s) **140** may comprise, e.g., small profile, media compatible, piezoresistive silicon pressure sensors packaged in a stainless-steel housing (e.g., MEAS 86A^{™} from T.E. connectivity^{™} or equivalent sensors).

In various embodiments, pressure-controlled paste reservoir **154** and paste pump **152** may open adjacently to exit opening(s) **169** of printing head **150** and paste filling unit **120** may comprise a conduit **135** connecting the exit of mixer **130** to entry opening(s) **161** of printing head **150.** In some embodiments, pressure-controlled paste reservoir **154** and paste pump **152** may open adjacently to exit opening(s) **169** of printing head **150,** mixer **130** may be adjacent to entry opening(s) **161** of printing head **150,** and conduit **135** may connect paste pump **152** to mixer **130.** Pressure sensor **140** may be associated with mixer **130.** The dimensions and orientations of paste reservoir **154** and paste pump **152** may vary, e.g., both paste reservoir **154** and paste pump **152** may be set perpendicularly to printing head **150** (see, e.g., **Figure 6A****),** or one or both of paste reservoir **154** and paste pump **154** may be set at an angle to printing head **150.** For example, paste pump **152** may be set obliquely to spread its weight more evenly over printing head **150,** as illustrated schematically in **Figures 6B** and **6C****.**

In various embodiments, conduit **135** may be adjusted to conform to any arrangement of paste reservoir **154,** paste pump **152** and mixer **130,** so as to make paste filling unit **120** more compact or adjust it to a given space and weight distribution requirements within the printing machine. Holder **145** (see, e.g., **Figure 6A****)** is illustrated schematically as an attachment element for attaching paste filling unit **120** to the printing machine (see, e.g., U.S. Patent No. 9,616,524 for a non-limiting example). In non-limiting examples, conduit **135** may be connected between an opening **131** in mixer **130** and an opening **138** of connector **137** at entry opening **161** in printing head **150** (see, e.g., **Figure 6A****)** or between opening **131** in paste pump **152** and opening **138** in mixer **130** (see, e.g., **Figure 6C****).**

Returning to **Figure 1B****,** tape **205** and the pattern transfer sheets may comprise at least one polymer layer, which may be selected from at least one of: polyethylene, polypropylene, polyethylene terephthalate, polybutylene terephthalate, polyethylene naphthalate, fully aromatic polyester, other copolymer polyester, polymethyl methacrylate, other copolymer acrylate, polycarbonate, polyamide, polysulfone, polyether sulfone, polyether ketone, polyamideimide, polyether imide, aromatic polyimide, alicyclic polyimide, fluorinated polyimide, cellulose acetate, cellulose nitrate, aromatic polyamide, polyvinyl chloride, polyphenol, polyarylate, polyphenylene sulfide, polyphenylene oxide, or polystyrene.

Trenches **210** may be periodic, and/or may comprise trenches, recesses and/or indentations that are embossed in a similar manner into top polymer layer **214,** and may have similar or different profiles. For example, trenches **210** may have various profiles (cross section shapes), such as trapezoid, rounded, square, rectangular and triangular profiles. In various embodiments, the pattern of trenches **210** on tape **205** may comprise continuous trenches **210** and/or arrays of separated dents. It is noted that the term "trenches" is not to be construed as limiting the shape of trenches **210** to linear elements, but is understood in a broad sense to include any shape of trenches **210.**

Tape **205** may comprise a top polymer layer **214** and a bottom polymer layer **212,** the bottom polymer layer **212** having a melting temperature that is higher than an embossing temperature of the top polymer layer **214.** In some embodiments, top polymer layer **214** may be made of semi-crystalline polymer and have a melting temperature, e.g., below 150°C, below 130°C, below 110°C or have intermediate values. In some embodiments, top polymer layer **214** may be made of amorphous polymer and have a glass temperature below 160°C, e.g., below 140°C, below 120°C, below 100°C or have intermediate values. Bottom polymer layer **212** may have a higher melting temperature than the melting temperature or the glass temperature of top polymer layer **214.** For example, bottom polymer layer **212** may have a melting temperature above 150°C, above 160°C (e.g., bi-axially-oriented polypropylene), above 170°C, and up to 400°C (e.g., certain polyimides), or have intermediate values.

In certain embodiments, top and bottom polymer layers **214, 212** (respectively) may be between 10µm and 100µm thick, e.g., between 15µm and 80µm thick, between 20µm and 60µm thick, between 25µm and 45µm thick, or have other intermediate values - with bottom polymer layer **212** being preferably at least as thick as top polymer layer **214.** The polymer layers may be attached by an adhesive layer **213** that is thinner than 10µm (e.g., thinner than 8µm, thinner than 6µm, thinner than 4µm, thinner than 2µm or have intermediate values) and is likewise transparent to the laser illumination. For example, in certain embodiments, top polymer layer **214** may be thicker than the depth of trenches **210** by several µm, e.g., by 5µm, by 3-7µm, by 1-9µm, or by up to 10µm. For example, trenches **210** may be 20µm deep, top polymer layer **214** may be 20-30µm thick and bottom polymer layer **212** may range in thickness between 25µm and 45µm (it is noted that thicker bottom polymer layer provide better mechanical performances). It is noted that the term "trenches" is not to be construed as limiting the shape of trenches **210** to linear elements, but is understood in a broad sense to include any shape of trenches **210.**

The temperature and thickness of top and bottom polymer layers **(214, 212** respectively) may be designed so that top polymer layer **214** has good molding, ductility and certain mechanical strength, while bottom polymer layer **212** has good mechanical strength. Both top and bottom polymer layers **(214, 212** respectively) may be designed to have good bonding properties.

In various embodiments, the supporting portion of pattern transfer sheet **205** may comprise a stretchable substrate with specified stretching properties, such as a polymer substrate, or the supporting portion of the pattern transfer sheet **205** may comprise a rigid substrate, such as a glass substrate.

In some embodiments, using disclsoed paste mixtures in PTP methods **500** may enable to print paste patterns (e.g., paste fingers) on receiving substrate **90** with a much higher aspect ratio, e.g., at least 0.7 and up to 1-2 - instead of prior art 0.4-0.5; as well as to print extremely narrow finger(s) and/or grid line(s), down to or below 10µm wide - instead of prior art above 25-30µm wide. Furthermore, avoiding use of volatile compounds in the paste mixture (in embodiments without NIR absorbing dyes) broadens the range of printable pastes and makes the process much less sensitive to drying of the paste mixture.

The printing paste layer may contain organic components and solid phase components of metals such as silver, copper, tin, or bismuth that may act as conductive media. The organic components may be selected to provide a specified pressure required to overcome the resistance of the printing paste layer to detaching from the trenches. The specified pressure may be achieved, e.g., by adjusting the content of the organic components in the printing paste layer and/or in the coating inside the trenches, and/or by adjusting the ratio of the solid phase component of the conductive metal medium. For example, in cases the printing paste layer has high viscosity and high damping property when in contact with the inner wall of the trenches, and/or if the content of the solid phase components is high, or the adhesion of organic components is strong, the resistance that the printing paste layer may be relatively large and the corresponding specified pressure may be configured to be larger as well.

Non-limiting examples for components of NIR absorbing dyes include Diimonium ionic complex(es), Dithiolene complex(es) and/or phthalocyanine. The illustrated Diimonium ionic complex may include, e.g., alkyl chain(s) as one or more residue(s) R and counter ions (not shown) such as *2SbF₆⁻.*

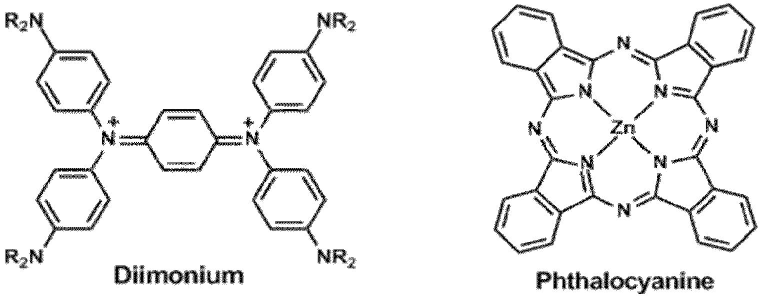

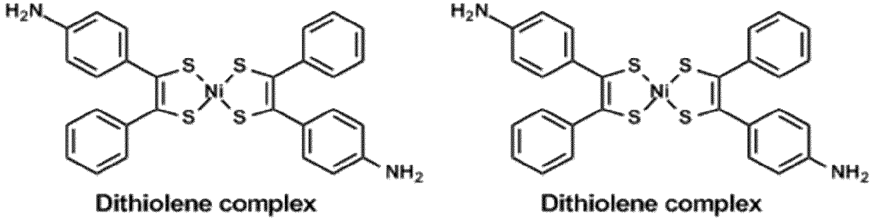

Additional, non-limiting examples for components of NIR absorbing dyes in any of the disclosed embodiments (as part of the coating and/or as part of the paste mixtures) may include any of cyanine (tetramethylindo(di)-carbocyanines) dyes such as, e.g., open chain cyanines (R₂N⁺=CH[CH=CH]ₙ⁻NR₂), hemicyanines (Aryl=N⁺=CH[CH=CH]ₙ-NR₂), closed chain cyanines (Aryl=N⁺=CH[CH=CH]ₙ-N=Aryl), neutrocyanines (R2N⁺=CH[CH=CH]ₙ-CN and R₂N⁺=CH[CH=CH]ₙ-CHO), e.g., with extended [CH=CH]ₙ chains, or variants or mixtures thereof; phthalocyanine or naphthalocyanine dyes (comprising four isoindole units linked by a ring of nitrogen atoms) or metal complexes thereof (e.g., with aluminum or zinc), dithiolene metal complexes (having one to three dithiolene ligands), e.g., with nickel, squaraine dyes such as squarylium dye III, quinone analogues, diimonium compounds and azo derivatives, and/or any of their variants, derivatives and/or combinations.

Advantageously, mixing NIR absorbing dyes directly into the paste mixture does not require addition of solvents or binders, and also hardly leaves any unwanted paste debris after transferring the paste lines to the silicon wafer. Moreover, disclosed mixtures also avoid using a separate release layer as described U.S. Application No. 17/971,689, and hence also avoid residues thereof from being deposited on the wafer.

Accordingly, the paste mixtures may comprise, in addition to commercially available printing pastes (e.g., SOL9651B^{™} from Heraeus^{™}) or paste mixtures with coarse and fine grained metal particles, NIR absorbing dyes such as Diimonium ionic complex(es), Dithiolene complex(es) and/or phthalocyanine as illustrated herein. It is noted that NIR absorbing dyes may be added to silver pastes and/or to silver epoxy paste mixtures.

Certain embodiments comprise a paste for use in a pattern transfer process (that includes filling the paste into trenches in the polymer pattern transfer sheet which are arranged in a specified pattern, and consecutively releasing the paste from the trenches onto the receiving substrate upon illumination by the laser beam). For example, in case the illumination is in NIR, the paste comprises a releasing material configured to enhance the releasing of the paste from the trenches, with the releasing material comprising at least one NIR absorbing dye comprising at least one of: a Diimonium ionic complex, a Dithiolene complex, phthalocyanine, derivatives, salts and/or combinations thereof. Non-limiting examples include dyes from TCI (Tokyo Chemical Industry, Ltd), Epolight^{™} 1117 (Tetrakis(decyl)ammonium structure) by Epolin ^{™} and/or Lunir5^{™} by Luminochem^{™}.

Various embodiments include methods and systems for applying a coating into the trenches, as disclosed in U.S. Application No. 17/971,689, which is incorporated herein by reference in its entirety. However, the inventors point out that advantageously, disclosed paste mixtures were transferred to form ultrafine lines (thin, straight, with high aspect ratio and little paste debris) - without need for any coating in the trenches.

Elements from **Figures 1A-6C** may be combined in any operable combination, and the illustration of certain elements in certain figures and not in others merely serves an explanatory purpose and is non-limiting.

In the above description, an embodiment is an example or implementation of the invention. The various appearances of "one embodiment", "an embodiment", "certain embodiments" or "some embodiments" do not necessarily all refer to the same embodiments. Although various features of the invention may be described in the context of a single embodiment, the features may also be provided separately or in any suitable combination. Conversely, although the invention may be described herein in the context of separate embodiments for clarity, the invention may also be implemented in a single embodiment. Certain embodiments of the invention may include features from different embodiments disclosed above, and certain embodiments may incorporate elements from other embodiments disclosed above. The disclosure of elements of the invention in the context of a specific embodiment is not to be taken as limiting their use in the specific embodiment alone. Furthermore, it is to be understood that the invention can be carried out or practiced in various ways and that the invention can be implemented in certain embodiments other than the ones outlined in the description above.

The invention is not limited to those diagrams or to the corresponding descriptions. For example, flow need not move through each illustrated box or state, or in exactly the same order as illustrated and described. Meanings of technical and scientific terms used herein are to be commonly understood as by one of ordinary skill in the art to which the invention belongs, unless otherwise defined. While the invention has been described with respect to a limited number of embodiments, these should not be construed as limitations on the scope of the invention, but rather as exemplifications of some of the preferred embodiments. Other possible variations, modifications, and applications are also within the scope of the invention. Accordingly, the scope of the invention should not be limited by what has thus far been described, but by the appended claims and their legal equivalents.

## Claims

1. A pattern transfer printing (PTP) method comprising:
handling a tape comprising, as sections thereof, a plurality of pattern transfer sheets having respective patterns of trenches, to controllably deliver the pattern transfer sheets for paste filling and consecutively for pattern transfer,
mixing, continuously and uniformly, at least two types of conductive printing pastes having different particle sizes - to form a uniform paste mixture,
filling the trenches on the delivered pattern transfer sheets with the paste mixture,
controllably delivering a plurality of wafers for the pattern transfer, and
transferring the paste mixture from the pattern transfer sheets onto the delivered wafers, by releasing the paste mixture from the trenches upon illumination by a laser beam.

2. The PTP method of claim 1, wherein the at least two types of conductive printing pastes comprise at least a first, coarse-grained type having a median particle size between 0.5-5 µm and a second, fine-grained type having a median particle size between 50-200nm.

3. The PTP method of claim 1 or 2, wherein the median particle size of the first, coarse-grained type is 2µm±1µm and the median particle size of the second, fine-grained type is 80nm±50nm.

4. The PTP method of any one of claims 1-3, wherein the mixing further comprises mixing, continuously and uniformly, a NIR (near infrared) absorbing dye configured to absorb at a wavelength of the illumination by the laser beam - to form the uniform paste mixture.

5. The PTP method of any one of claims 1-4, configured to form transferred paste lines that are at most 10µm wide and have an aspect ratio of at least 0.8.

6. The PTP method of any one of claims 1-5, configured to form transferred paste lines that are uniform and have a low waviness, with minimal debris.

7. A pattern transfer printing (PTP) method comprising:
handling a tape comprising, as sections thereof, a plurality of pattern transfer sheets having respective patterns of trenches, to controllably deliver the pattern transfer sheets for paste filling and consecutively for pattern transfer,
mixing, continuously and uniformly, at least one type of conductive printing paste with a NIR (near infrared) absorbing dye - to form a uniform paste mixture,
filling the trenches on the delivered pattern transfer sheets with the paste mixture,
controllably delivering a plurality of wafers for the pattern transfer, and transferring the paste mixture from the pattern transfer sheets onto the delivered wafers, by releasing the paste mixture from the trenches upon illumination by a laser beam,
wherein the NIR absorbing dye is configured to absorb at a wavelength of the illumination by the laser beam.

8. The PTP method of claim 7, wherein the mixing further comprises mixing, continuously and uniformly, at least two types of conductive printing pastes having different particle sizes - to form a uniform paste mixture.

9. The PTP method of claim 8, wherein the at least two types of conductive printing pastes comprise at least a first, coarse-grained type having a median particle size between 0.5-5 µm and a second, fine-grained type having a median particle size between 50-200nm.

10. The PTP method of claim 8 or 9, wherein the median particle size of the first, coarse-grained type is 2µm±1µm and the median particle size of the second, fine-grained type is 80nm±50nm.

11. The PTP method of any one of claims 8-10, configured to form transferred paste lines that are at most 10µm wide and have an aspect ratio of at least 0.8.

12. The PTP method of any one of claims 8-10, configured to form transferred paste lines that are uniform and have a low waviness, with minimal debris.
